**Europäisches Patentamt**

**European Patent Office**

**Office européen des brevets**

(19)

(11) Numéro de publication: **0 262 055**
**B1**

(12) FASCICULE DE BREVET EUROPEEN

(45) Date de publication du fascicule du brevet:
**24.10.90**

(21) Numéro de dépôt: **87420225.2**

(22) Date de dépôt: **25.08.87**

(51) Int. Cl.⁵: **G01B 11/24**

(54) Procédé de mesure du fluage d'un matériau.

(30) Priorité: **26.08.86 FR 8612294**

(43) Date de publication de la demande:
**30.03.88 Bulletin 88/13**

(45) Mention de la délivrance du brevet:
**24.10.90 Bulletin 90/43**

(84) Etats contractants désignés:
**BE DE GB IT NL**

(56) Documents cités:
**DE-A- 2 537 563**
**US-A- 3 985 444**
**US-A- 4 140 397**

**PATENT ABSTRACTS OF JAPAN, vol. 10, no. 290 (P-503)**
**[2346], 2 octobre 1986; & JP-A-61 108 917 (MITSUBISHI**
**HEAVY IND. LTD) 27-05-1986**
**LASERELEKTROOPTIK,**
**vol. 10, no. 3, septembre 1978, pages 16-19, Stuttgart,**
**DE; K. DORENWENDT et al.: "Längsmessungen an**
**technischen Körpern mit beugungsoptischen**
**Methoden"**

(73) Titulaire: **Tissier, Annie, 10 Les Plantées Biviers,**
**F-38330 Saint-Ismier(FR)**
Titulaire: **DUTARTRE, Didier, 4, allée du Bret,**
**F-38240 Meylan(FR)**

(72) Inventeur: **Tissier, Annie, 10 Les Plantées Biviers,**
**F-38330 Saint-Ismier(FR)**
Inventeur: **DUTARTRE, Didier, 4, allée du Bret,**
**F-38240 Meylan(FR)**

(74) Mandataire: **de Beaumont, Michel, 1bis, rue**
**Champollion, F-38000 Grenoble(FR)**

**Description**

La présente invention concerne un procédé pour mesurer directement au cours du fluage thermique d'un matériau le degré de fluage de ce matériau.

La présente invention s'applique notamment au domaine des circuits intégrés où elle sera utile pour des opérations de contrôle de qualité en cours de fabrication.

Dans la réalisation des circuits intégrés, des couches isolantes à base de silice ($SiO_2$) sont fréquemment utilisées, notamment pour isoler des couches conductrices successives de la structure du circuit intégré. Ces couches de silice sont généralement formées à partir d'un dépôt de silice sur toute la surface d'une plaquette de circuit intégré, cette couche étant ensuite gravée par divers procédés de photolithogravure incluant une attaque chimique ou une attaque au plasma. Les bords de parties de couches de silice restantes après les attaques sont généralement très raides et forment des marches. Ceci peut entraîner lors du dépôt ultérieur d'une couche métallique, telle qu'une couche d'aluminium, un mauvais recouvrement des bords et éventuellement des cassures du métal et donc des ouvertures de circuit de conduction. On cherche donc à arrondir les bords des parties de couches de silice. Ceci est généralement réalisé en effectuant un recuit à une température supérieure à la température de transition vitreuse du verre pour entraîner son fluage. Bien souvent, pour réduire la température de cette étape thermique, on incorpore au verre un "dopant" tel que du bore et/ou du phosphore.

Il est souhaitable de réduire autant que possible la durée de l'étape thermique de fluage. Cette durée doit être suffisante pour obtenir un arrondi souhaité des flancs et ne doit pas être trop longue. D'une part, toute étape thermique lors de la fabrication d'un circuit intégré a des réactions sur les opérations qui ont été précédemment effectuées dans le circuit. Notamment, elle entraîne une diffusion des dopants incorporés préalablement par diffusion à l'intérieur de couches semiconductrices et modifie donc le profil des zones actives. D'autre part, un fluage excessif peut être préjudiciable au bon fonctionnement des circuits, à cause par exemple d'un amincissement extrême de l'isolant sur certains reliefs.

C'est là que se pose le problème que vise à résoudre de façon générale la présente invention. En effet, les couches minces de silice obtenues par exemple par dépôt chimique en phase vapeur et dopées sont peu reproductibles en ce qui concerne leur composition, en particulier lors de dépôts assistés par plasma. Comme la viscosité du verre dépend très fortement de son dopage, des petites fluctuations de compositions de plaquette à plaquette et de lot de fabrication à lot de fabrication vont entraîner des modifications importantes dans la vitesse de fluage et donc dans les profils obtenus.

Ainsi, actuellement, pour fixer la durée de l'étape de fluage, on procède à une analyse aux rayons X ou à une analyse chimique de la teneur en dopant d'une couche de silice mais ces analyses donnent seulement une valeur globale de la teneur en dopant alors que seuls le bore ou le phosphore solubilisé sous forme de $B_2O_3$ ou de $P_2O_5$ agissent sur la température de transition vitreuse. On ne peut donc obtenir une mesure permettant de déduire des valeurs de cycle thermique précises.

Un autre procédé consiste à effectuer un test sur une plaquette témoin, c'est-à-dire que, sur une plaquette témoin, on fait un essai de fluage puis on clive la plaquette et on observe au microscope électronique la forme des marches. On utilise ensuite pour le lot de plaquette réelles la valeur optimale obtenue sur les plaquettes témoins. Ce procédé présente bien entendu l'inconvénient de nécessiter une plaquette témoin et de réaliser sur celle-ci de nombreuses opérations.

Le document "Laserelektrooptik, vol. 10, no. 3, sept. 1978, pages 16–19" divulgue un procédé pour deternir la forme d'un objet, dans lequel les bandes parallèles sont éclairées constituant un réseau de diffraction, et dans lequel la structure de la figure de diffraction est analysée.

Ainsi, un objet de la présente invention est de prévoir un procédé permettant de mesurer in situ l'évolution du fluage d'une couche de matériau.

Pour atteindre cet objet, la présente invention prévoit un procédé de mesure du fluage d'un matériau comprenant les étapes consistant à : former un réseau de bandes parallèles dudit matériau formant un réseau de diffraction ; soumettre ledit réseau aux mêmes conditions que le matériau dont on souhaite contrôler le fluage ; éclairer le réseau par un faisceau lumineux monochromatique ; et observer l'évolution de la lumière diffractée au cours du fluage.

L'étape d'observation de la lumière diffractée comprend les étapes consistant à mesurer l'intensité d'au moins une tache lumineuse de l'image diffractée et à déduire de ladite mesure la déformation des bandes du réseau.

Plus particulièrement, la présente invention prévoit un procédé dans lequel ledit matériau comprend des parties d'une couche de silice éventuellement dopée formée sur une plaquette de circuit intégré en cours de fabrication et dans lequel ledit réseau est formé sur une partie de l'une au moins d'un ensemble de plaquettes traitées simultanément.

Dans un appareil pour la mise en oeuvre de la présente invention, la source lumineuse peut être un laser monochromatique.

Ces objets, caractéristiques et avantages ainsi que d'autres de la présente invention seront exposés plus en détail dans la description suivante d'un mode de réalisation particulier faite en relation avec les figures jointes parmi lesquels :

la figure 1 est destinée à illustrer de façon générale le procédé selon la présente invention ;

les figures 2A-3A, 2B-3B, 2C-3C et 2D-3D représentent des allures de bandes d'un réseau de diffraction et les figures de diffraction correspondantes.

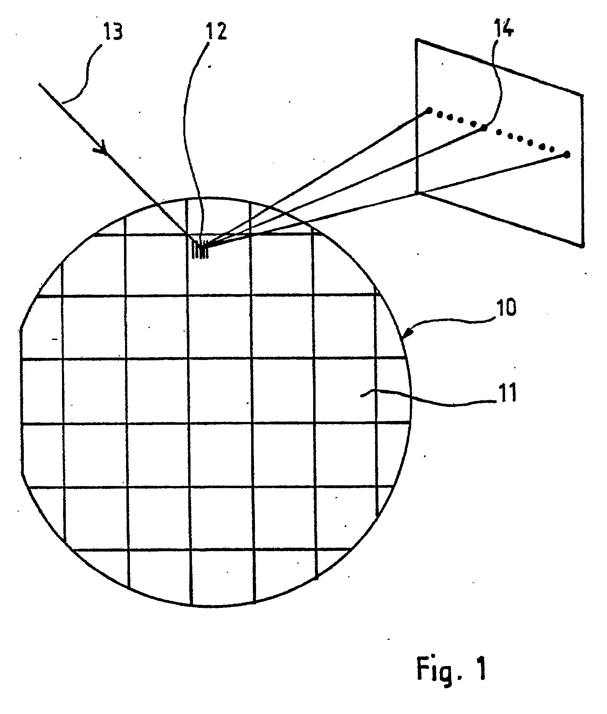

La figure 1 illustre de façon très schématique une mise en oeuvre particulière de la présente invention. Etant donné une plaquette 10 sur/dans laquelle de nombreux circuits adjacents sont en cours de formation à l'intérieur de blocs 11 (habituellement des carrés ou des rectangles), lors d'une étape de dépôt de silice qui doit être amené ensuite à fluer après photogravure, on effec tue simultanément un dépôt de silice à un emplacement 12 de la plaquette correspondant par exemple à un emplacement inutilisé lors de cette étape de fabrication ; et on grave alors la silice dans ledit emplacement selon un motif de bandes parallèles ayant par exemple sensiblement la largeur et l'écartement correspondant à la largeur et à l'écartement type des plus petites bandes de silice que l'on souhaite faire fluer dans des zones actives de la plaquette, par exemple couramment de 1 à 5 microns. Ce motif de bande constitue un réseau de diffraction optique. Ainsi, si l'on éclaire l'emplacement 12 par un faisceau lumineux 13 on observera sur un écran une tache lumineuse principale 14 correspondant à la réflexion spéculaire et de nombreuses taches adjacentes alignées de diffraction. Les divers paramètres du montage optique pourront facilement être choisis en ayant recours à la littérature courante, par exemple pour déterminer la longueur d'onde appropriée du faisceau incident, les angles d'incidence et les systèmes optiques à interposer éventuellement.

Le réseau 12 est donc constitué du même matériau que celui que l'on veut faire fluer et est déposé sur un même substrat. Ainsi, le fluage des bandes du réseau 12 se produira de la même manière que celui des bandes des couches actives dont on veut surveiller l'évolution.

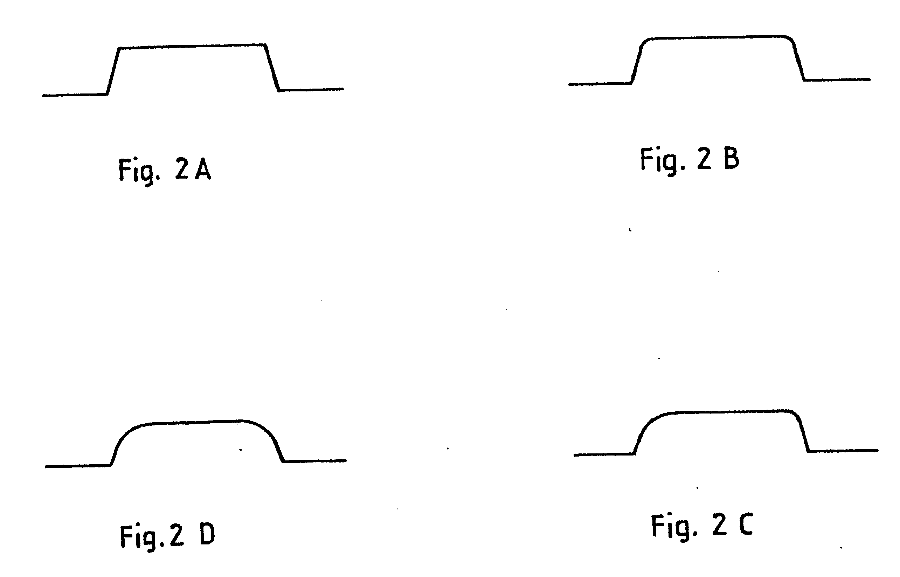

Les figures 2A à 2D représentent des vues en coupe d'une bande du réseau utilisée dans la présente invention, cette bande ayant par exemple une largeur de 3 microns et étant espacée d'une bande parallèle d'une même dimension. De la figure 2A à la figure 2D, le degré de fluage augmente.

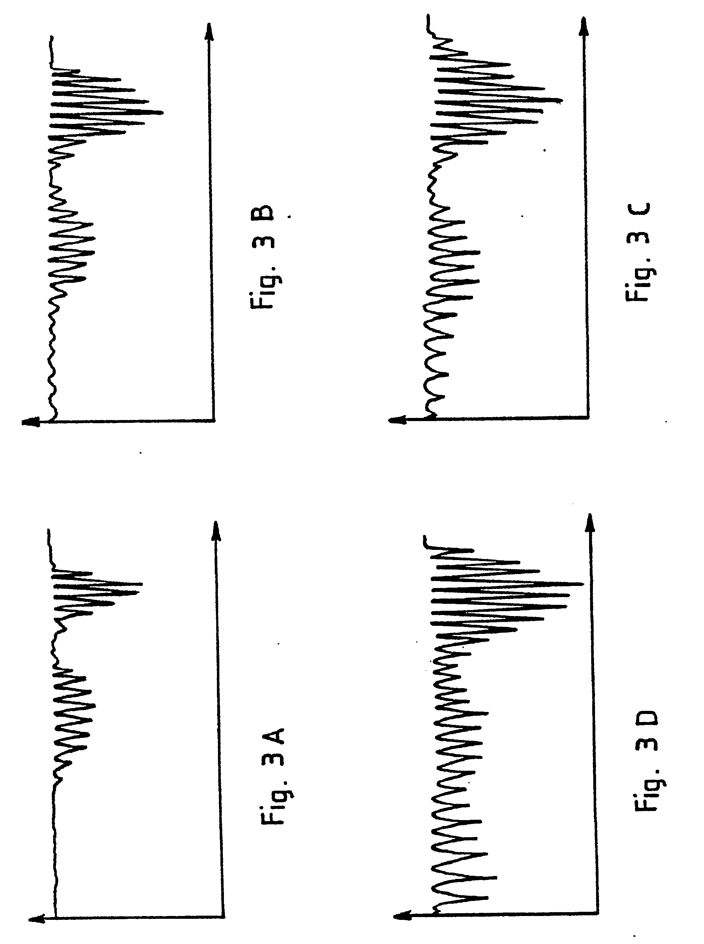

Les figures 3A à 3D représentent les figures de diffraction correspondantes, c'est-à-dire les intensités des divers spots successifs. Ces intensités peuvent par exemple être mesurées par un analyseur se déplaçant le long de la figure de diffraction ou par échantillonnage au moyen d'une barrette de diodes. On notera que la figure de diffraction se déforme relativement régulièrement tandis que le degré de fluage augmente.

Dans le cas des figures 2A et 3A (avant fluage), on observe une série de spots lumineux intenses au voisinage de la tache de réflexion spéculaire et une seconde série de spots lumineux moins intenses mais relativement intenses de part et d'autre de la réflexion spéculaire (un seul côté est représenté sur les figures). Comme le montre les figures 3B à 3D, tandis que le niveau de fluage augmente, l'intensité relative des taches les plus intenses par rapport aux taches les moins intenses décroît et les taches latérales deviennent de plus en plus intenses. On a donc une corrélation directe entre la forme des bandes constituant le réseau de diffraction et le spectre de diffraction obtenu. Ces formes pourraient d'ailleurs être calculées à priori en utilisant les théories optiques classiques. Plus simplement, on pourra faire une série de tests et analyser ces formes. Ensuite, on pourra par exemple s'intéresser à une tache de diffraction d'un certain ordre et étudier sa variation par rapport à une tache de diffraction d'un autre ordre, ces deux taches étant choisies de façon particulièrement caractéristique dans le spectre. Et l'on en déduira directement une mesure du degré de fluage. On pourra en conséquence arrêter le processus de fluage exactement au moment où l'on a atteint l'état désiré.

Dans une application à des circuits intégrés, on a représenté en figure 1 le fait qu'un motif de réseau constitué à partir du matériau que l'on veut faire fluer est présent sur l'une des puces d'une plaquette. Il peut s'agir d'une puce réelle dans laquelle on a introduit le motif de réseau dans une zone non utilisée au moins à l'étape de fabrication considérée. Il peut également s'agir d'une puce témoin placée à un endroit particulier de la plaquette. Si le processus de fluage est mis en oeuvre alors que l'on traite un lot de plaquettes, le motif de réseau pourra être placé sur chacune des plaquettes, à condition d'être dans une zone de la plaquette facilement accessible pour laisser passer un faisceau incident et les faisceaux diffractés. Ce motif peut également être présent sur une seule plaquette active ou encore sur une plaquette témoin traitée dans le même lot.

Ainsi, ce procédé permet, par analyse de la variation de la figure de diffraction par un moyen quelconque, par exemple par calcul ou par étalonnage, d'optimiser l'étape de fluage en s'affranchissant :
- des variations non contrôlées de la composition de la silice dopée ;
- des variations de viscosité de la silice pouvant provenir de modifications dans l'atmosphère de travail ;
- des incertitudes thermiques provenant soit de la machine de recuit, soit de l'échantillon (épaisseur, réflectivité moyenne...) dans le cas de recuits transitoires.

D'autre part, la présente invention permet d'éviter d'utiliser des plaquettes témoins traitées avant le lot utile. Tout au plus, pourra-t-on utiliser une plaquette témoin traitée en même temps que le lot utile.

Dans un mode de réalisation pratique, le présent procédé a été appliqué sur une plaquette de silicium d'un diamètre de 100 mm en procédant aux étapes successives suivantes :
- dépôt chimique en phase vapeur de silice dopée à 8 % de phosphore,
- dépôt de résine photosensible,
- insolation à travers un masque comportant sur une certaine zone des bandes parallèles et régulièrement espacées, et révélation de la résine,
- retrait par plasma de la résine,
- positionnement de la plaquette dans un four de recuit fonctionnant avec des lampes,
- positionnement d'un laser de type hélium/néon fonctionnant à une longueur d'onde de 632,8 nm de façon qu'il éclaire le réseau réalisé dans la silice recouvrant la plaquette, le faisceau laser étant compris dans le plan défini par un trait du réseau et une perpendiculaire à l'échantillon,
- détection des spots diffractés par observation sur un écran placé perpendiculairement au spot d'ordre 0 (réflexion spéculaire),
- recuit à 1170°C.

Selon une variante de la présente invention, on notera également que, dans de nombreux circuits intégrés, il se trouve que l'on est amené à graver des bandes parallèles et régulières de silice que l'on cherche ensuite à faire fluer. Ceci se produit par exemple dans des structures régulières de mémoires ou de réseaux logiques. En ce cas, on pourra utiliser directement le procédé selon la présente invention sur ces motifs utiles sans réaliser de motif auxiliaire particulier comme cela a été décrit précédemment.

## Revendications

1. Procédé de mesure du fluage d'un matériau, caractérisé en ce qu'il comprend les étapes suivantes:
- former un réseau de bandes parallèles dudit matériau formant un réseau de diffraction;
- soumettre ledit réseau aux mêmes conditions que le matériau dont on souhaite provoquer et contrôler le fluage;
- éclairer le réseau par un faisceau lumineux monochromatique;
- mesurer l'évolution de l'intensité d'au moins une tache lumineuse de l'image diffractée au cours du fluage; et
- déduire de ladite mesure la déformation des bandes du réseau.

2. Procédé de mesure du fluage d'un matériau selon la revendication 1, caractérisé en ce que ledit matériau comprend des parties d'une couche de silice éventuellement dopée formée sur une plaquette de circuit intégré en cours de fabrication et en ce que ledit réseau est formé sur une partie de l'une au moins d'un ensemble de plaquettes traitées simultanément.

## Patentansprüche

1. Verfahren zum Messen des Fließens eines Materials, dadurch gekennzeichnet, daß es die folgenden Schritte aufweist:
- Ausbilden eines Gitters aus parallelen Streifen dieses Materials, das ein Beugungsgitter darstellt,
- Unterwerfen dieses Gitters denselben Bedingungen wie das Material, dessen Fließen bewirkt und gesteuert werden soll,
- Beleuchten des Gitters mit einem monochromatischen Lichtstrahl,
- Messen der Intensitätsänderung wenigstens eines Lichtflecks des während des Fließvorgangs gebeugten Bildes und
- Ableiten der Deformation der Streifen des Materials aus dieser Messung.

2. Verfahren zum Messen des Fließens eines Materials nach Anspruch 1, dadurch gekennzeichnet, daß das Material Abschnitte einer gegebenenfalls dotierten Siliziumoxidschicht auf einem Wafer für eine integrierte Schaltung während des Herstellvorgangs aufweist und daß das Gitter auf einem Abschnitt ausgebildet ist, wenigstens einer von vielen gleichzeitig behandelten Wafer-Anordnungen.

## Claims

1. A method for measuring the flowing of a material characterized in this that it comprises the following steps:
- forming an array of parallel stripes of said material constituting a diffraction grating;
- submitting said grating to the same conditions as the material, the flowing of which is to be carried out and monitored;
- illuminating the grating with a wingle wavelength light beam;
- measuring the variation of the intensity of at least one light spot of the diffracted image during the flowing; and
- deducing from said measure the deformation of the grating stripes.

2. The method of measuring the flowing of a material according to claim 1, characterized in that said material comprises portions of a possibly doped silica layer formed onto an integrated circuit wafer being manufactured and said grating is formed onto a portion of at least one of a set of simultaneously treated wafers.

Fig. 1

Fig. 2 A

Fig. 2 B

Fig. 2 C

Fig.2 D

Fig. 3 A

Fig. 3 B

Fig. 3 D

Fig. 3 C

EP 0 262 055 B1